# FASCICULE DE BREVET EUROPEEN

(11) **EP 1 995 815 B1**
(45) Date de publication et mention de la délivrance du brevet: **08.12.2010**
(21) Numéro de dépôt: 08290475.6
(22) Date de dépôt: 22.05.2008
(51) Int. Cl.: H01M 10/0562, H01M 10/052, H01M 10/04, G02F 1/15, H01M 4/38, H01M 4/485

(54) **Verre organique électrolytique, son procédé de fabrication et dispositif le comprenant**
Elektrolytisches organisches Glas, dessen Herstellungsverfahren und Vorrichtung dasselbe enthaltend
Electrolytic organic glass, process for the production thereof and device comprising the same

(30) Priorité: 25.05.2007 FR 0703723
(43) Date de publication de la demande: 26.11.2008
(73) Titulaire: Commissariat à l'Énergie Atomique et aux Énergies Alternatives, 75015 Paris (FR)
(72) Inventeur: Martin, Steve, 38160 Saint Sauveur (FR); Salot, Raphael, 38250 Lans-en-Vercors (FR); Faucherand, Pascal, 38360 Sassenage (FR); Oukassi, Sami, Bizerte 7000 (TN); Jodin, Lucie, 54000 Nancy (FR)
(74) Mandataire: Noel, Chantal Odile

(56) Documents cités:
- WO-A-2006/059794
- FR-A- 2 536 740
- FR-A- 2 601 017
- S. ZHAO ET AL.: "Li-V-Si-O thin film electrolyte for all-solid-state Li-ion battery" JOURNAL OF POWER SOURCES, vol. 122, no. 2, 23 juillet 2003 (2003-07-23), pages 174-180, XP004437060 ISSN: 0378-7753
- DATABASE INSPEC [Online] février 1997 (1997-02), X. YU ET AL.: "A stable thin-film lithium electrolyte : lithium phosphorus oxynitride" XP002459575 Database accession no. 5542869 & JOURNAL OF THE ELECTROCHEMICAL SOCIETY, vol. 144, no. 2, février 1997 (1997-02), pages 524-532, ISSN: 0013-4651

## Description

L'invention concerne un électrolyte solide, un procédé pour sa fabrication ainsi que des dispositifs le comprenant.

Les microbatteries au lithium sont utilisées dans des dispositifs électroniques de petites tailles ainsi que dans des dispositifs semi-conducteurs.

L'électrolyte est un élément très influent sur les performances électriques de ces microbatteries.

En effet, les défaillances observées lors du cyclage sont souvent liées à une dégradation électrochimique de l'électrolyte au contact du lithium.

Les performances des microbatteries sont étroitement liées aux propriétés électriques de l'électrolyte, telles que la conductivité ionique et électronique.

Ces microbatteries sont utilisées dans les cartes à puces, les étiquettes intelligentes, l'alimentation d'horloges internes et de microsystèmes.

Toutes ces applications imposent que toutes les couches nécessaires au fonctionnement de la batterie soient, d'une part, solides et, d'autre part, fabriquées avec des techniques compatibles avec les procédés industriels de la microélectronique.

Parmi les électrolytes solides on distingue deux familles: les polymères et les verres.

Dans les électrolytes polymères solides, un sel de lithium est directement dissous dans la matrice polymère. La conductivité ionique est communément attribuée à la mobilité des ions Li⁺ au sein de la matrice amorphe du polymère solide.

Cependant les électrolytes polymères solides présentent une basse température de transition vitreuse, ce qui génère la formation de zones cristallines susceptibles de piéger les ions Li⁺ et d'inhiber leur mobilité.

De plus, la méthode d'élaboration des électrolytes polymères ne permet pas la réalisation de dépôts conformes aux substrats, c'est-à-dire ayant la même épaisseur en tous points du substrat.

C'est pour ces deux raisons que l'électrolyte aujourd'hui communément employé dans la réalisation d'une microbatterie est un verre.

Par verre, on entend un matériau amorphe.

Parmi les verres décrits dans l'art antérieur, seuls les verres inorganiques tels que le LiPON (Lithium Phosphore OxyNitrure), le LiSON (Lithium Soufre OxyNitrure), LiSiPON (Lithium Silicium Phosphore OxyNitrure) sont utilisés comme électrolytes.

Dans cette famille, le LiPON est l'électrolyte solide le plus utilisé dans les microbatteries actuelles car il présente une bonne stabilité électrochimique face au lithium. Cependant, il a une conductivité ionique relativement faible, de l'ordre de 2 x 10⁻⁶ S.cm⁻¹ à température ambiante, comparée à celle de certains électrolytes polymères.

Par ailleurs, les verres organiques tels que le carbone amorphe (a-CxHy) ou les PDMS-like (SiOₓC_{y}H_{z}) sont couramment utilisés en microélectronique. Mais dans ce cas, ils sont employés comme isolants dans les niveaux d'interconnexions et non comme un verre organique électrolytique.

La demande PCT WO 2006/059794 A divulgue une batterie secondaire aux ions lithium tout solide qui comprend comme électrolyte une substance inorganique comprenant des cristaux conducteurs d'ions lithium.

Le document Journal of Power Sources, vol. 122, no. 2, 23 juillet 2003, pages 174-180, XP004437060, décrit une méthode de préparation d'un film mince d'électrolyte solide de type Li-V-Si-O pour batterie secondaire aux ions lithium tout solide.

Le document Journal of the Electrochemical Society, vol. 144, no. 2, février 1997, pages 524-532, XP002459575, décrit la préparation et les propriétés d'un film mince d'électrolyte au lithium constitué par du Lithium Phosphore Oxynitrure (LiPON).

La demande de brevet français n°2 601 017 décrit une composition à base de dérivés de silice modifiée par des groupements organiques pouvant être utilisée comme électrolyte solide. Ces compositions sont à base de silice et non de lithium.

La demande de brevet français n°2 536 740 décrit un verre inoniquement conducteur destiné à être utilisé comme électrolyte solide à base de lithium.

Cependant, aucun de ces documents ne décrit un électrolyte solide comprenant à la fois des ions lithium et des oxydes ainsi qu'une partie organique comprenant du carbone et de l'hydrogène.

Pour pallier les inconvénients des électrolytes solides pour microbatteries au lithium de l'art antérieur, l'invention propose un matériau électrolytique, c'est-à-dire permettant la conduction des ions lithium, déposable de façon conforme, stable à température ambiante et possédant une conductivité ionique supérieure à 1 x 10⁻⁶ S.cm⁻¹.

A cet effet, l'invention propose un électrolyte solide, amorphe, qui est un verre organique de formule I suivante:

SiᵥO_{w}CₓH_{y}Li_{z} Formule I

dans laquelle v, w, x,y et z sont des pourcentages atomiques avec
0 ≤ v ≤ 40,
5 ≤ w ≤ 50,
x > 12,
10 ≤ y ≤ 40,
1 ≤ z ≤ 70, et
95% ≤ v+w+x+y+z ≤ 100.

L'électrolyte solide de l'invention se distingue des électrolytes polymères de l'art antérieur en ce qu'il ne s'agit pas d'un polymère et qu'il ne possède donc pas de température de transition vitreuse.

L'électrolyte selon l'invention se distingue des électrolytes qui sont des verres de l'art antérieur par sa composition chimique : il contient du carbone et donc une phase organique.

De tels matériaux amorphes, solides, du type verre organique ne sont, a priori, pas favorables pour obtenir de bons électrolytes dans la mesure où la stabilité de la partie organique vis-à-vis du lithium n'est généralement pas bonne.

Cependant, on a maintenant découvert que la stabilité chimique de l'électrolyte de l'invention vis-à-vis du lithium était augmentée lorsque le niveau de réticulation de l'électrolyte solide de l'invention était augmenté, ce niveau étant caractérisé par le niveau de dureté du matériau.

Cependant, l'augmentation de la réticulation bien qu'augmentant la stabilité de l'électrolyte de l'invention vis-à-vis du lithium réduit en même temps sa conduction ionique.

On pense, sans vouloir être lié par cette théorie, que la réduction de cette conduction ionique est due à l'augmentation de la densité du matériau.

Mais, on a également découvert que la présence de la phase organique dans l'électrolyte solide de l'invention permet une relaxation du réseau favorisant la conduction ionique.

Ainsi, lorsque l'électrolyte solide de l'invention contient plus de 12 % atomique de carbone, de préférence entre 20 et 40 % atomique de carbone, et une dureté supérieure ou égale à 0,5 GPa, mais inférieure à 20 GPa, l'électrolyte solide amorphe obtenu est à la fois stable chimiquement vis-à-vis du lithium, et présente de bonnes propriétés de conduction ionique.

La dureté de l'électrolyte solide de l'invention a été mesurée par nanoindentation.

A cet effet, on utilise un appareil de mesure de nanodureté CSM en mode multicycles en continu (continuous multicyle mode), en utilisant un embout d'indentation Berkovich.

La pointe de l'embout d'indentation, placée sur la surface dont la dureté est à mesurer, est entraînée dans l'échantillon en appliquant une charge. La charge est ensuite diminuée jusqu'à ce que la relaxation partielle ou complète du matériau se produise. La courbe charge-profondeur est ensuite utilisée pour calculer les propriétés mécaniques telles que la dureté et le module d'élasticité.

Ici, une charge initiale de 1 mN augmentée jusqu'à 10 mN a été utilisée jusqu'à obtenir une empreinte, laissée par l'application de la charge, de 100 à 200 nm. Toutes les mesures ont été effectuées sur des échantillons de 2 µm d'épaisseur.

Plus précisément, le verre électrolytique organique de l'invention contient, en pourcentage atomique, plus de 12 % de carbone, de préférence entre 20 et 40 % de carbone, entre 1 et 70 % de lithium, de préférence entre 20 et 40 % de lithium, entre 5 et 50 % d'oxygène, de préférence entre 15 et 30 % d'oxygène, et entre 0 et 40 % de silicium, de préférence entre 0 et 15 % de silicium, et entre 10 et 40% d'hydrogène, de préférence entre 15 et 30 % d'hydrogène, la somme des pourcentages atomiques de carbone, lithium, oxygène, silicium et hydrogène étant au moins égale à 95%.

En effet, bien que le verre électrolytique organique de l'invention puisse ne comprendre que du carbone, du lithium, de l'oxygène, du silicium et de l'hydrogène, on peut également prévoir de le doper par ajout de matériaux tels que le fluor, le bore, le phosphore ou l'azote ou leurs mélanges pour lui conférer une plus grande résistance chimique vis-à-vis de l'atmosphère ou une meilleure couverture de marche.

Ainsi, l'électrolyte de l'invention peut comprendre en outre au plus 5% atomique d'au moins un élément dopant.

L'électrolyte de l'invention est obtenu par dépôt chimique en phase vapeur par plasma d'un précurseur carboné gazeux auquel est ajouté un précurseur gazeux lithié et un gaz porteur neutre tel que l'hélium.

Le précurseur carboné permet d'obtenir une matrice vitreuse du type a-CₓH_{y} ou SiOₓC_{y}H_{z} et peut être de l'héxaméthyldisiloxane (HMDSO), du tétraéthyloxysilane (TEOS), de l'octaméthylcyclotétrasiloxane (OMCTSO), C₇H₈, C₆H₁₂, CH₄, C₉H₁₀, C₂H₂, te tétrahydrofurane (THF) ou un mélange de un ou plusieurs de ces précurseurs carbonés.

Le précurseur lithié, pour fonctionnaliser la matrice vitreuse du type carbone amorphe ou SiOₓC_{y}H_{z}, est de préférence du lithium héxaméthyledisilazane (LiHMDS), du lithium tétraméthylheptanedionate (LiTMHD), du lithium terbutoxyde (LiTBO), du lithium acétylacétonate (LiAcac) ou un mélange de l'un ou plusieurs de ces précurseurs lithiés.

L'électrolyte de l'invention répond aux exigences des microbatteries tout-solide au lithium, aux exigences des systèmes électrochromes et en général de tout accumulateur au lithium.

Son procédé de fabrication est un procédé compatible avec les procédés utilisés dans la microélectronique qui permet la réalisation d'un dépôt à une basse température, c'est-à-dire à une température inférieure à 300°C et, de plus le procédé permet de contrôler les épaisseurs déposées d'électrolyte solide au nanomètre près et ce à des vitesses de dépôts supérieures à 5 µm par heure.

L'invention sera mieux comprise et d'autres détails et avantages de celle-ci apparaîtront plus clairement à la lecture de la description explicative qui suit et qui est faite en référence aux figures dans lesquelles:
- la Figure 1 représente schématiquement un appareil de dépôt chimique en phase vapeur par plasma permettant le dépôt et la fabrication de l'électrolyte de l'invention,
- la Figure 2 représente les courbes d'analyse calorimétrique différentielle d'un électrolyte polymère classique et d'un électrolyte organique vitreux selon l'invention,
- La Figure 3 représente les mesures de spectroscopie d'impédance réalisées sur des électrolytes organiques vitreux de l'invention présentant respectivement une dureté de 2,3 GPa et de 20 GPa.
- la Figure 4 représente schématiquement une vue en coupe d'une microbatterie planaire au lithium comprenant un électrolyte de l'invention et,
- La Figure 5 est une représentation schématique d'une microbatterie au lithium à architecture tridimensionnelle comprenant une couche d'électrolyte selon l'invention.

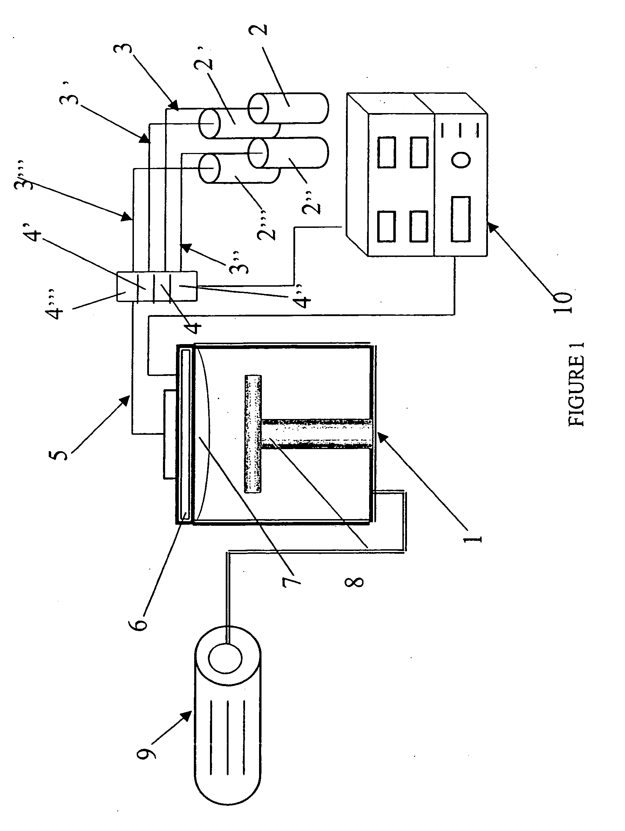

Tout d'abord, le procédé de fabrication de l'électrolyte de l'invention sera décrit en référence à la Figure 1.

Le précurseur lithié gazeux, le précurseur carboné gazeux et le gaz porteur ainsi que l'éventuel élément dopant sont stockés chacun indépendamment dans une des enceintes notées 2, 2',2" et 2"' en Figure 1. Ils sont amenés via les canalisations notées 3, 3', 3" et 3"' en Figure 1, à des débitmètres notés 4, 4', 4" et 4"' qui permettent de contrôler la stoechiométrie du composé final à obtenir.

Le mélange gazeux, contenant les proportions souhaitées de précurseur lithié, de précurseur carboné, éventuellement d'éléments dopants, et de gaz porteur est ensuite amené par la canalisation, notée 5 en Figure 1, dans l'enceinte plasma, notée 1 en Figure 1.

Le mélange gazeux est injecté via un système d'injection de type douche, noté 6 en Figure 1, dans l'enceinte plasma 1. L'enceinte plasma 1 est maintenue à une pression de 1 mbar par une pompe à vide, notée 9 en Figure 1.

Puis le mélange gazeux est soumis à un plasma radiofréquence, noté 7 en Figure 1. L'électrolyte solide de l'invention de la composition chimique voulue est alors déposé à l'épaisseur voulue, sur le substrat voulu (non représenté) qui est placé sur un porte substrat, noté 8 en Figure 1.

La pression dans l'enceinte plasma 1 et la puissance du plasma radiofréquence sont contrôlées grâce aux appareils de contrôle, notés 10 en Figure 1.

L'utilisation d'un plasma comme vecteur d'énergie et activateur des réactions chimiques permet une décomposition poussée des précurseurs introduits dans l'enceinte, et ce d'une manière aléatoire, ce qui fait que le matériau obtenu ne peut pas être décrit, comme c'est le cas pour un polymère, par une formule générique de type [X]ₙ où X représente une chaîne carbonée "brique de base" et n la répartition de cette brique. Ainsi, l'ordre à grande échelle n'est pas conservé. Le matériau obtenu est amorphe et vitreux. L'absence de longue chaîne polymère explique l'absence de température de transition vitreuse et de phénomène de recristallisation à l'origine des instabilités généralement observées dans les électrolytes polymères.

Afin de mieux faire comprendre l'invention, on va en décrire ci-après plusieurs exemples de mise en oeuvre qui sont donnés uniquement à titre illustratif et ne doivent pas être considérés comme limitatifs de l'invention.

### Exemple 1: Synthèse d'un électrolyte solide de formule SiOCHLi.

En utilisant l'appareillage montré en Figure 1 et décrit ci-dessus, un électrolyte solide de formule C₃₈ O₂₁ H₂₂ Lᵢ₁₉ a été obtenu par injection dans l'enceinte plasma d'un mélange gazeux contenant 500 sccm (cm³ standard par mn) de tétrahydrofurane (THF), de 10 sccm de lithium terbutoxyde (LiTBO) et 200 sccm d'hélium.

L'ensemble du mélange gazeux est injecté dans l'enceinte de plasma 1 et soumis à un plasma noté 7 de radiofréquence 13,56 MHz d'une puissance de 100 watts pendant 20 minutes.

Pendant tout le dépôt, la pression globale dans l'enceinte plasma 1 est maintenue à 1 mbar.

La dureté de l'électrolyte obtenu était de 2,3 GPa

### Exemple 2: Analyse calorimétrique différentielle.

L'électrolyte solide de l'invention obtenu à l'exemple 1 ainsi que l'électrolyte polymère le plus répandu dans l'art antérieur qui est le polyéthylène oxyde (PEO) ont été analysés par analyse calorimétrique différentielle.

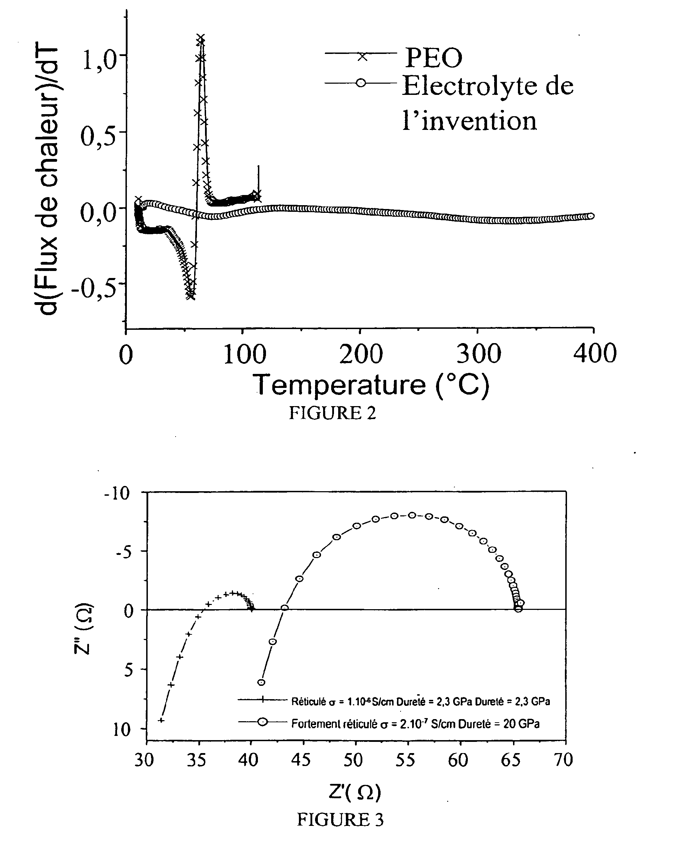

La Figure 2 représente les courbes obtenues en fonction de la température.

Comme on le voit en Figure 2, la courbe de calorimétrie différentielle du polyéthylène oxyde présente un pic de transition vitreuse clairement défini à une température de 60°C alors qu'aucun changement notable n'est observé avec l'électrolyte solide de l'invention.

En ce sens, les électrolytes organiques vitreux lithiés de l'invention permettent de résoudre le problème de la stabilité thermique de l'électrolyte solide.

### Exemple 3: Mise en évidence de l'influence du taux de réticulation de l'électrolyte selon l'invention sur sa conductivité.

Un électrolyte solide ayant la même formule que l'électrolyte solide de l'exemple 1 a été préparé de la même manière qu'à l'exemple 1, sauf la puissance plasma qui est de 300 W pendant 20 minutes, ce qui a mené à l'obtention d'un électrolyte ayant une dureté de 20 GPa.

Une mesure de spectroscopie d'impédance a alors été réalisée sur l'électrolyte solide obtenu de l'exemple 1 et sur l'électrolyte solide obtenu à cet exemple 3.

La figure 3 représente les courbes d'impédance obtenues.

Comme on le voit en Figure 3, la conductivité ionique associée à l'électrolyte obtenu à l'exemple 1 est de 3.10⁻⁶ S/cm alors que cette conductivité ionique chute à 2.10⁻⁷ S/cm avec l'électrolyte obtenu à cet exemple 3.

Ainsi, la dureté de l'électrolyte de l'invention doit être maintenue entre 0,5 et 20 GPa, inclus.

### Exemple 4: Fabrication d'une microbatterie planaire.

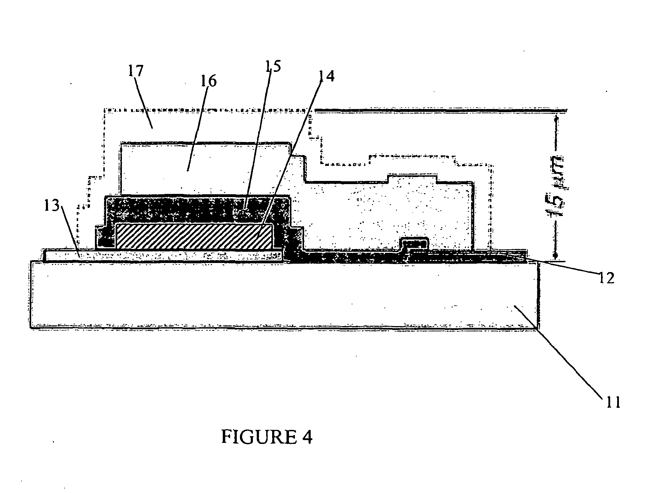

Un exemple de microbatterie planaire est schématisé à la Figure 4.

Comme on le voit en Figure 4, la microbatterie planaire est constituée de l'empilement successif des couches suivantes:
- un substrat en silicium noté 11 en Figure 4,
- un collecteur de courant anodique en or noté 12 en Figure 4,
- un collecteur de courant cathodique en or noté 13 en Figure 4,
- une cathode en oxyde de vanadium (V₂O₅) notée 14 en Figure 4,
- un électrolyte solide selon l'invention, noté 15 en Figure 4,
- une anode en lithium, noté 16 en Figure 4, et
- une couche d'encapsulation en parylène, notée 17 en Figure 4.

Pour réaliser cette microbatterie planaire, le substrat de silicium 11 muni de ses deux collecteurs de courant en or (12, 13) est revêtu de la couche en V₂O₅, constituant la cathode, par un procédé connu dans l'art tel qu'une pulvérisation cathodique DC ou RF à partir d'une cible de vanadium ou de V₂O₅ en présence d'oxygène.

L'électrolyte est ensuite déposé par la technique décrite à l'exemple 1 ci-dessus. Puis, l'anode est déposée par évaporation sous vide d'une source de lithium.

Enfin, l'ensemble est encapsulé dans du poly-para-xylène ou parylène.

### Exemple 5: Fabrication d'une microbatterie tridimensionnelle.

L'architecture à trois dimensions de la microbatterie permet d'augmenter la surface active de stockage tout en conservant une surface apparente identique. L'utilisation de l'électrolyte solide de l'invention est particulièrement adaptée dans ce genre d'architecture qui nécessite de déposer les matériaux constitutifs de la microbatterie de façon conforme.

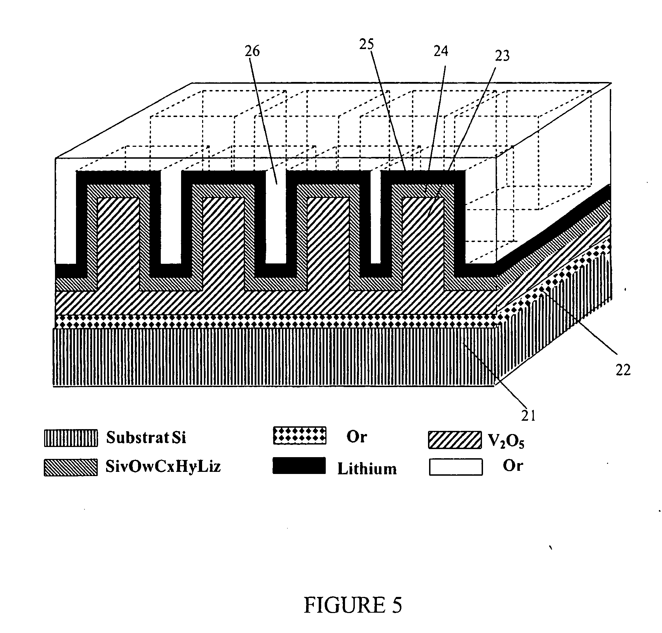

La Figure 5 est une représentation schématique d'une microbatterie à architecture tridimensionnelle.

Comme on le voit en Figure 5, la microbatterie à architecture tridimensionnelle est constituée d'un substrat en silicium, noté 21 en Figure 5, revêtu d'une couche d'un matériau collecteur de courant cathodique en or, notée 22 en Figure 5.

Une couche, notée 23 en Figure 5, en oxyde de vanadium, V₂O₅, qui est la cathode, est déposée sur la couche 22. Cette couche 23 d'oxyde de vanadium est déposée selon un motif tridimensionnel par un procédé connu dans l'art, tel qu'une pulvérisation cathodique DC ou RF à partir d'une cible de vanadium ou de V₂O₅ en présence d'oxygène. Cette couche 23 est ensuite texturée par des techniques de photolithographie.

Une couche, notée 24 en Figure 5, d'un électrolyte -selon l'invention est ensuite déposée par la technique décrite à l'exemple 1 de façon à suivre le motif tridimensionnel de la couche de cathode 23.

Ensuite, une couche d'anode en lithium, notée 25 en Figure 5, est déposée sur la couche 24 d'électrolyte solide de l'invention par évaporation sous vide d'une source de lithium.

Enfin, une couche de collecteur de courant anodique en or, notée 26 en Figure 5, est déposée sur l'anode toujours en respectant le motif tridimensionnel obtenu grâce à la texturation par photolithographie de la couche 23 de cathode en V₂O₅.

### Exemple 6: Réalisation d'un système électrochrome.

Les électrolytes à base de verre organique de l'invention peuvent également être utilisés dans les systèmes électrochromes.

Dans ce type de système, l'application d'une tension permet d'insérer ou de désinsérer un cation (par exemple du lithium) d'un matériau dont la coloration évolue avec l'état d'oxydation. Ce matériau est en contact avec un électrolyte qui assure la source de cation.

Le dispositif réalisé avec l'électrolyte solide de l'invention est obtenu par exemple par l'empilement successif des couches suivantes:
- un substrat en verre,
- un collecteur de courant en oxyde d'indium et d'étain (ITO) obtenu par pulvérisation cathodique DC,
- un matériau électrochrome cathodique en WO₃ obtenu par pulvérisation cathodique DC sous atmosphère d'argon + oxygène, suivie d'un recuit,
- un matériau électrolyte selon l'invention,
- un matériau électrochrome anodique en ZrO₂ obtenu par pulvérisation cathodique DC,
- un collecteur de courant en ITO obtenu par pulvérisation cathodique DC, et
- une encapsulation transparente en parylène.

## Revendications

1. Electrolyte **caractérisé en ce qu'**il est un solide amorphe de formule I suivante:
SiᵥO_{w}CₓH_{y}Li_{z} Formule I
dans laquelle v, w, x,y et z sont des pourcentages atomiques avec
0 ≤ v ≤ 40,
5 ≤ w ≤ 50,
x > 12,
10 ≤ y ≤ 40,
1 ≤ z ≤ 70, et
95%≤ v+w+x+y+z ≤100%.

2. Electrolyte selon la revendication 1, **caractérisé en ce que** dans la formule I:
0 ≤ v ≤ 15,
15 ≤ w ≤ 30,
20 ≤ x ≤ 40,
15 ≤ y ≤ 30, et
20 ≤ z ≤ 40.

3. Electrolyte selon la revendication 1 ou 2, **caractérisé en ce qu'**il comprend en outre au plus 5 % atomique d'au moins un élément dopant.

4. Electrolyte selon la revendication 3, **caractérisé en ce que** ledit au moins un élément dopant est choisi dans le groupe constitué par le fluor, le bore, le phosphore, l'azote ou les mélanges de ceux-ci.

5. Procédé de fabrication d'un électrolyte solide selon l'une quelconque des revendications précédentes, **caractérisé en ce qu'**il comprend le dépôt chimique en phase vapeur par plasma d'un mélange gazeux comprenant :
- un gaz carboné précurseur,
- un précurseur lithié gazeux, et
- un gaz porteur neutre tel que l'hélium,
sur le support voulu.

6. Procédé selon la revendication 5, **caractérisé en ce que** ledit gaz carboné précurseur est choisi parmi l'héxaméthyldisiloxane (HMDSO), le tétraéthyloxysilane (TEOS), l'octaméthylcyclotétrasiloxane (OMCTSO), C₇H₈, C₆H₁₂, CH₄, C₉H₁₀, C₂H₂, le tétrahydrofurane (THF), et leurs mélanges, et **en ce que** ledit précurseur lithié gazeux est choisi parmi le lithium héxaméthyledisilazane (LiHMDS), le lithium tétraméthylheptanedionate (LiTMHD), le lithium terbutoxyde (LiTBO), le lithium acétylacétonate (LiAcac) et leurs mélanges.

7. Microbatterie tout solide, **caractérisée en ce qu'**elle comprend un électrolyte selon l'une quelconque des revendications 1 à 4 ou obtenu par le procédé selon la revendication 5 ou 6.

8. Système électrochrome, **caractérisé en qu'**il comprend un électrolyte selon l'une quelconque des revendications 1 à 4 ou obtenu par le procédé selon la revendication 5 ou 6.

9. Accumulateur au lithium, **caractérisé en ce qu'**il comprend un électrolyte selon l'une quelconque des revendications 1 à 4 ou obtenu par la procédé selon la revendication 5 ou 6.

## Claims

1. Electrolyte, **characterised in that** it is an amorphous solid of the following formula I:
SiᵥO_{w}CₓH_{y}Li_{z} formula I
wherein v, w, x, y and z are atomic percentages where
0 ≤ v ≤ 40,
5 ≤ w ≤ 50,
x > 12,
10 ≤ y ≤ 40,
1 ≤ z ≤ 70, and
95% ≤ v+w+x+y+z ≤ 100%.

2. Electrolyte according to claim 1, **characterised in that** in formula I:
0 ≤ v ≤ 15,
15 ≤ w ≤ 30,
20 ≤ x ≤ 40,
15 ≤ y ≤ 30, and
20 ≤ z ≤ 40.

3. Electrolyte according to claim 1 or 2, **characterised in that** it further comprises at most 5% atomic of at least one doping element.

4. Electrolyte according to claim 3, **characterised in that** the at least one doping element is selected from among fluorine, boron, phosphorus, nitrogen or mixtures thereof.

5. Method of manufacturing a solid electrolyte according to any one of the preceding claims, **characterised in that** it comprises chemical vapour plasma deposition of a gaseous mixture comprising:
- a carbonaceous precursor gas,
- a gaseous lithium-containing precursor, and
- a neutral carrier gas such as helium,
on the desired substrate.

6. Method according to claim 5, **characterised in that** the carbonaceous precursor gas is selected from among hexamethyldisiloxane (HMDSO), tetraethyloxysilane (TEOS), octamethylcyclotetrasiloxane (OMCTSO), C₇H₈, C₆H₁₂, C₉H₁₀, C₂H₂, tetrahydrofuran (THF) and mixtures thereof, and **in that** the gaseous lithium-containing precursor is selected from among lithium hexamethyldisilazane (LiHMDS), lithium tetramethylheptanedionate (LiTMHD), lithium tert.butoxide (LiTBO), lithium acetylacetonate (LiAcac) and mixtures thereof.

7. Completely solid microbattery, **characterised in that** it comprises an electrolyte according to any one of claims 1 to 4 or obtained by the method according to claim 5 or 6.

8. Electrochromic system, **characterised in that** it comprises an electrolyte according to any one of claims 1 to 4 or obtained by the method according to claim 5 or 6.

9. Lithium accumulator, **characterised in that** it comprises an electrolyte according to any one of claims 1 to 4 or obtained by the method according to claim 5 or 6.

## Patentansprüche

1. Elektrolyt, **dadurch gekennzeichnet, dass** er ein amorpher Feststoff der nachfolgenden Formel I ist:
SiᵥO_{w}CₓH_{y}Li_{z} Formel 1
wobei v, w, x, y und z Atomprozente sind mit
0 ≤ v ≤ 40,
5 ≤ w ≤ 50,
x > 12,
10 ≤ y ≤ 40,
1 ≤ z ≤ 70 und
95 % ≤ v+w+x+y+z ≤ 100 %.

2. Elektrolyt nach Anspruch 1, **dadurch gekennzeichnet, dass** in Formel I:
0 ≤ v ≤ 15,
15 ≤ w ≤ 30,
20 ≤ x ≤ 40,
15 ≤ y ≤ 30 und
20 ≤ z ≤ 40.

3. Elektrolyt nach Anspruch 1 oder 2, **dadurch gekennzeichnet, dass** er zusätzlich höchstens 5 at % von mindestens einem Dotierelement umfasst.

4. Elektrolyt nach Anspruch 3, **dadurch gekennzeichnet, dass** das mindestens eine Dotierelement aus der aus Fluor, Bor, Phosphor, Stickstoff oder deren Mischungen bestehenden Gruppe ausgewählt ist.

5. Verfahren zur Herstellung eines Feststoffelektrolyten gemäß einem der vorhergehenden Ansprüche, **dadurch gekennzeichnet, dass** es die plasmaunterstütze chemische Abscheidung aus der Dampfphase von gasförmigen Mischungen, umfassend:
- einen Gas-Präkursor auf Kohlenstoffbasis,
- einen gasförmigen Präkursor auf Lithiumbasis und
- ein neutrales Trägergas wie Helium,
auf dem gewünschten Träger umfasst.

6. Verfahren nach Anspruch 5, **dadurch gekennzeichnet, dass** der Gas-Präkursor auf Kohlenstoffbasis ausgewählt ist aus Hexamethyldisiloxan (HMDSO), Tetraethyloxysilan (TEOS), Octamethylcyclotetrasiloxan (OMCTSO), C₇H₈, C₆H₁₂, CH₄, C₉H₁₀, C₂H₂, Tetrahydrofuran (THF) und deren Mischungen, und der gasförmige Präkursor auf Lithiumbasis ausgewählt ist aus Lithiumhexamethyldisilazan (LiHMDS), Lithiumtetramethylheptandionat (LiTMHD), Lithium-tert-butoxid (LiTBO), Lithiumacetylacetonat (LiAcac) und deren Mischungen.

7. Vollstandig feste Mikrobatterie, **dadurch gekennzeichnet, dass** sie einen Elektrolyt gemäß einem der Ansprüche 1 bis 4 oder erhalten durch ein Verfahren gemäß dem Anspruch 5 oder 6 umfasst.

8. Elektrochromes System, **dadurch gekennzeichnet, dass** es einen Elektrolyt gemäß einem der Ansprüche 1 bis 4 oder erhalten durch ein Verfahren gemäß dem Anspruch 5 oder 6 umfasst.

9. Lithiumakkumulator, **dadurch gekennzeichnet, dass** er einen Elektrolyt gemäß einem der Ansprüche 1 bis 4 oder erhalten durch ein Verfahren gemäß dem Anspruch 5 oder 6 umfasst.
